(19) Europäisches Patentamt / European Patent Office / Office européen des brevets

(11) **EP 2 787 354 B1**

(12) **EUROPEAN PATENT SPECIFICATION**

(45) Date of publication and mention of the grant of the patent:
**03.10.2018 Bulletin 2018/40**

(51) Int Cl.:
*G08C 15/00* (2006.01)   *G08C 17/00* (2006.01)
*H02J 13/00* (2006.01)   *G01R 21/133* (2006.01)
*H04Q 9/00* (2006.01)   *G01D 4/00* (2006.01)
*G01R 22/06* (2006.01)   *G01R 31/02* (2006.01)

(21) Application number: **12845331.3**

(22) Date of filing: **31.01.2012**

(86) International application number:
**PCT/JP2012/052182**

(87) International publication number:
**WO 2013/065328 (10.05.2013 Gazette 2013/19)**

(54) **POWER MEASURING APPARATUS, POWER MEASURING SYSTEM, AND POWER MEASURING METHOD**

LEISTUNGSMESSVORRICHTUNG, LEISTUNGSMESSSYSTEM UND VERFAHREN ZUR LEISTUNGSMESSUNG

APPAREIL DE MESURE DE PUISSANCE, SYSTÈME DE MESURE DE PUISSANCE ET PROCÉDÉ DE MESURE DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.10.2011 JP 2011239565**

(43) Date of publication of application:
**08.10.2014 Bulletin 2014/41**

(73) Proprietor: **Mitsubishi Electric Corporation Tokyo 100-8310 (JP)**

(72) Inventors:
• **ISHIHARA Masahiro Tokyo 100-8310 (JP)**
• **KOIZUMI Yoshiaki Tokyo 100-8310 (JP)**
• **KOMATSU Kazuhiro Tokyo 100-0006 (JP)**

(74) Representative: **Pfenning, Meinig & Partner mbB Patent- und Rechtsanwälte Theresienhöhe 11a 80339 München (DE)**

(56) References cited:
JP-A- H0 491 637    JP-A- 2003 149 272
JP-A- 2004 222 375    JP-A- 2004 222 375
JP-A- 2004 274 116    JP-A- 2008 306 835
JP-A- 2008 306 835    JP-A- 2010 051 138

## Description

Technical Field

The present disclosure relates to a power measuring apparatus, a power measuring system, and a power measuring method.

Background Art

An air conditioning energy-saving control device has been known from before that is provided with means for storing a control schedule for air conditioning equipment, means for acquiring power used by the air conditioning equipment measured by a power gauge installed in the air conditioning equipment, and means for forecasting power used by the air conditioning equipment based on the used power and the control schedule, and that controls the air conditioning equipment so that the forecast power used is not greater than a prescribed electric power (for example, see Patent Literature 1).

JP 2003 149272 A discloses: A quantity-of-electricity monitoring apparatus comprises a current transformer and a transformer at electric circuits for connecting a power-receiving section (plug) for taking in the power of a load section to a plug socket for supplying power to the load section, an arithmetic processing section for calculating current, voltage, power, electric energy, power factor, frequency, or the harmonics of voltage based on each signal of the current transformer and the transformer, and a display section for displaying the output information of the arithmetic processing section.

JP 2004 222375 A shows: A quantity-of-load-feature detector exists between the electric equipment and a power cable, gets the quantity of features supplied to the electric equipment via the power cable during current application to the electric equipment, and sends out this data on the quality of features via a communication line. A management device has a quantity-of-feature data base which has stored beforehand the data on the quantity of features corresponding to each kind of electric equipment relating them to individual attribute data, identifies the connected electric equipment by collating the data on the quantity of features registered in the quantity-of-feature data base, quantity-of-feature data of the identified electric equipment.

Citation List

Patent Literature

Patent Literature 1: Unexamined Japanese Patent Application Kokai Publication No. 2010-065960

Summary of Invention

Technical Problem

However, a power measuring apparatus such as a wattmeter and/or the like is normally installed on a metal distribution board or control board housed in equipment such as air conditioning equipment, so wireless communication with the air conditioner energy-saving control device is difficult. Consequently, with the system disclosed in Patent Literature 1, when installing the power measuring apparatus in existing equipment, it is necessary to lay a new communication line from the power measuring apparatus to the air conditioning energy-saving control device, creating the problem that installation costs are high.

In consideration of the foregoing, it is an objective of the present disclosure to provide a power measuring apparatus that can be installed in equipment with lower installation costs than in the past, and a power measuring system and power measuring method that can measuring the power of equipment at lower cost than in the past.

Solution to Problem

In order to achieve the above objective, the power measuring apparatus according to the present disclosure comprises:

line connecting means connected to a line supplying power to equipment;
measuring means for measuring current and voltage impressed on the equipment by the line connected thereto;
calculating means for calculating power consumed by the equipment based on the measured voltage and current;
transmission line connecting means connected to a monitoring transmission line over which data used in monitoring the equipment is transmitted; and

transmitting means for transmitting data indicating the calculated power to the monitoring transmission line.

Advantageous Effects of Invention

The power measuring apparatus according to the present disclosure can be installed in equipment with lower installation costs than in the past. In addition, with the power measuring system and power measuring method according to the present disclosure, it is possible to measure the power of equipment at lower cost than in the past.

Brief Description of Drawings

FIG. 1 is a composition diagram showing one composition example of a power measuring system according to a first preferred embodiment of the present disclosure;
FIG. 2 is a composition diagram showing one composition example of equipment;
FIG. 3 is a composition diagram showing one composition example of a power measuring apparatus;
FIG. 4 is a hardware composition diagram showing one example of the hardware composition of a calculator;
FIG. 5 is a flowchart showing one example of a power measuring process executed by the power measuring apparatus according to the first preferred embodiment;
FIG. 6 is a function block diagram showing one example of functions possessed by the power measuring apparatus according to the first preferred embodiment;
FIG. 7 is a flowchart showing one example of a sampling process executed by the power measuring apparatus;
FIG. 8 is a flowchart showing one example of a consumed power monitoring process executed by a controller;
FIG. 9 is a flowchart showing one example of a power measuring process executed by a power measuring apparatus according to a second preferred embodiment;
FIG. 10 is a function block diagram showing one example of functions possessed by the power measuring apparatus according to the second preferred embodiment;
FIG. 11 is a flowchart showing one example of a communication address detection process executed by the power measuring apparatus according to the second preferred embodiment;
FIG. 12 is a composition diagram showing one composition example of equipment according to a third preferred embodiment;
FIG. 13 is a composition diagram showing one composition example of a first main body of a power measuring apparatus according to the third preferred embodiment; and
FIG. 14 is a composition diagram showing one composition example of a second main body of the power measuring apparatus according to the third preferred embodiment.

Description of Embodiments

<First preferred embodiment>

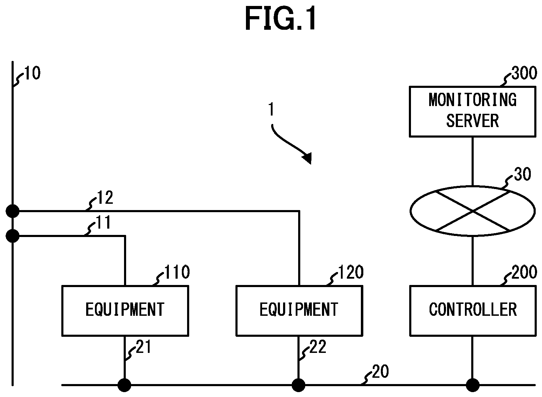

Below, a power measuring system 1 according to a first preferred embodiment of the present disclosure is described with reference to the attached drawings.
As shown in FIG. 1, the power measuring system 1 comprises a three-phase alternating current power source 10, a monitoring control transmission line 20, a communication network 30, equipment 110 and 120, a controller 200 and a monitoring server 300.
The three-phase alternating current power source 10 is connected to the equipment 110 via a power source line 11, and is connected to the equipment 120 via a power source line 12. The three-phase alternating current power source 10 is the source of power for the equipment 110 and the equipment 120, and comprises a first phase (hereafter called the R phase), a second phase (hereafter called the S phase) and a third phase (hereafter called the T phase) in which the phases of the current or voltage are mutually out of sync.
The monitoring control transmission line 20 is connected to the equipment 110 via a transmission line 21, and is connected to the equipment 120 via a transmission line 22. The monitoring control transmission line 20 is used in communicating monitoring signals for monitoring the equipment 110 or the equipment 120 or control signals for controlling the equipment 110 or the equipment 120. Monitoring signals and control signals communicated via the monitoring control transmission line 20 are overlaid on a direct current power source and transmitted to the equipment 110 and 120 and the controller 200.
The communication network 30 is the Internet and is connected to the controller 200 and the monitoring server 300. The communication network 30 may also be a LAN (Local Area Network) or a public circuit network.

The equipment 110 and the equipment 120 comprise air conditioning equipment such as indoor equipment or outdoor equipment. The equipment 110 and the equipment 120 have the same composition, so the explanation below is primarily for the equipment 110, and explanation of the equipment 120 is appropriately omitted.

The equipment 110 for example receives from the controller 200 a control signal indicating a temperature, air volume or operation mode set by a user, and operates in accordance with the control signal received. In addition, the equipment 110, upon receiving a monitoring signal from the monitoring server 300 via the controller 200, for example transmits a status signal indicating the operating status including power consumption of the equipment 110 to the monitoring server 300 via the controller 200.

The controller 200 comprises a modem device connectable to the monitoring server 300 via the communication network 30. The controller 200 has a button used in setting the temperature, air volume or operation mode, for example, and a control signal indicating the temperature, air volume or operation mode set by the user by manipulating the button is sent to the equipment 110 and 120. In addition, the controller 200 receives status signals from the equipment 110 and 120 and sends the status signals received to the monitoring server 300 and also accomplishes a display in accordance with the status signals.

The monitoring server 300 receives status signals for the equipment 110 and 120 from the controller 200 and monitors the operation status of the equipment 110 and 120 based on the signals received.

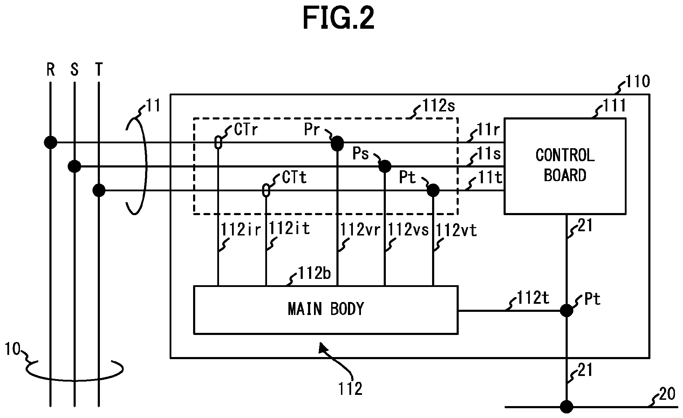

Next, the composition of the equipment 110 is described in detail with reference to FIG. 2.

The equipment 110 comprises a control circuit board (hereafter called a control board) 111 and a power measuring apparatus 112, as shown in FIG. 2.

The control board 111 is composed primarily of metal, is connected to the three-phase alternating current power source 10 via the power source line 11 and is connected to the monitoring control transmission line 20 via the transmission line 21. The control board 111 operates using a power source supplied from the three-phase alternating current power source 10. In addition, the control board 111, upon receiving a control signal from the monitoring control transmission line 20, causes an actuator to operate in accordance with the control signal received, and through this controls operation of the equipment 110. Furthermore, the control board 111, upon receiving a monitoring signal from the controller 200 via the monitoring control transmission line 20, sends a status signal for the equipment 110 to the controller 200 via the monitoring control transmission line 20.

The power measuring apparatus 112 comprises a line connector 112s connected to the power source line 11, a transmission line connector Pt connected to the transmission line 21, and a main body 112b connected to the line connector 112s and the transmission line connector Pt.

The line connector 112s comprises a point Pr connected to the R phase 11r of the power source line 11, a point Ps connected to the S phase 11s of the power source line 11, a point Pt connected to the T phase 11t of the power source line 11, a transformer CTr placed on the R phase 11r of the power source line 11 and a transformer CTt placed on the T phase 11t of the power source line 11. Lines 112vr, 112vs and 112vt, along with a line 112ir and a line 112it, connected to the main body 112b, are respectively connected to the points Pr, Ps and Pt and the transformers CTr and CTt. In addition, the transmission line 112t connected to the main body 112b is connected to the transmission line connector Pt.

The points Pr, Ps and Pt are for example clip-shaped and are removably connected to the R phase 11r, S phase 11s and T phase 11t, respectively, of the power source line 11.

The transformers CTr and CTt are removably connected to the R phase 11r and the T phase 11t of the power source line 11, similar to the points Pr and Pt, respectively. The transformers CTr and CTt are current transformers for measuring the current of the R phase 11r and the current of the T phase 11t, respectively, and for example are clamp-type current transformers with high workability.

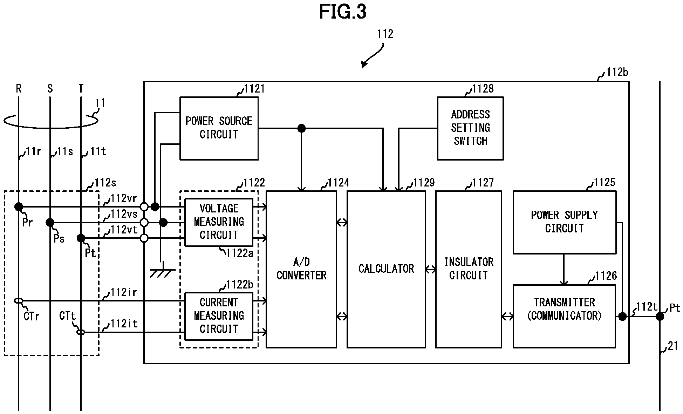

The main body 112b of the power measuring apparatus 112 houses a power source circuit 1121, a measuring circuit 1122 comprising a voltage measuring circuit 1122a and a current measuring circuit 1122b, an A/D (analog/digital) converter 1124, a power supply circuit 1125, a transmitter 1126, an insulator circuit 1127, an address setting switch 1128 and a calculator 1129, as shown in FIG. 3.

The power supply circuit 1121 comprises for example a rectifying circuit such as a diode, and a chopper-type DC (Direct Current)/DC converter. The power source circuit 1121 is connected to the line 112vr and the line 112vs grounded by being connected to the metal casing of the main body 112b, and the voltage between the R-S phases of the three-phase alternating current power source 10 is impressed. The power source circuit 1121 generates a direct-current power source using the impressed voltage between the R-S phases, and the generated direct current power source is provided to the A/D converter 1124 and the calculator 1129.

The voltage measuring circuit 1122a comprises, for example, a resistance divider circuit and is connected to the lines 112vr, 112vs and 112vt. The voltage measuring circuit 1122a divides the voltage between the R-S phases and the voltage between the S-T phases of the three-phase alternating current power source 10 to a level that can be input to the A/D converter 1124. In addition, the voltage measuring circuit 1122a inputs the divided voltage between the R-S phases (hereafter called the divided R-S phase voltage) and the divided voltage between the S-T phases (hereafter called the divided S-T phase voltage) into the A/D converter 1124.

The current measuring circuit 1122b comprises a load resistance of the transformer CTr. The current measuring circuit 1122b has electric current output from the transformer CTr input via the line 112ir, and impresses a voltage corresponding to the input current (hereafter called voltage in accordance with the R-phase current) on the A/D converter 1124. Similarly, the current measuring circuit 1122b further comprises a load resistance of the transformer CTt. The current measuring circuit 1122b has electric current output from the transformer CTt input via the line 112it, and impresses a voltage corresponding to the input current (hereafter called voltage in accordance with the T-phase current) on the A/D converter 1124.

The A/D converter 1124 comprises for example a high resolution A/D converter such as a $\Delta\Sigma$ A/D converter and/or the like. The A/D converter 1124 operates using the direct current power source supplied from the power source circuit 1121. Specifically, when a trigger signal from the calculator 1129 is input, the A/D converter 1124 respectively samples the instantaneous value of the divided R-S phase voltage and the instantaneous value of the divided S-T phase voltage, and the instantaneous value of the voltage in accordance with the R-phase current and the instantaneous value of the voltage in accordance with the T-phase current, with roughly the same timing. The A/D converter 1124 outputs to the calculator 1129 a digital signal SVrs indicating the instantaneous value of the divided R-S phase voltage (hereafter called the voltage value signal SVrs) and a digital signal SVst indicating the instantaneous value of the divided S-T phase voltage (hereafter called the voltage value signal SVst), and a digital signal SIr indicating the instantaneous value of the voltage in accordance with the R-phase current (hereafter called the current value signal SIr) and a digital signal SIt indicating the instantaneous value of the voltage in accordance with the T-phase current (hereafter called the current value signal SIt).

The transmission line connector Pt is for example a clip-type and is removably connected to the transmission line 21.

The power supply circuit 1125 comprises a chopper-type DC/DC converter, for example. The power supply circuit 1125 is supplied with a direct current power source from the transmission line 21 connected via the transmission line 112t and the transmission line connector Pr. The power supply circuit 1125 generates a power source used in operating the transmitter 1126 using the direct current power source supplied from the transmission line 21.

The transmitter 1126 comprises for example a communication circuit known as a communication driver. The transmitter 1126 operates using the power source supplied from the power supply circuit 1125. Specifically, the transmitter transmits a signal indicating data output from the calculator 1129 to the controller 200 via the transmission line 112t in accordance with a predetermined protocol. Conversely, the transmitter 1126 receives signals sent via the transmission line 112t from the controller 200 and outputs the received signal to the calculator 1129 via the insulator circuit 1127.

The insulator circuit 1127 comprises for example a photocoupler, and insulates the transmitter 1126 from the three-phase alternating current power source 10.

The address setting switch 1128 comprises for example a DIP (Dual In-line Package) switch and a rotary switch. The address setting switch 1125 outputs a signal (hereafter called a setting address signal) indicating an address specified so as to be read into the calculator 1129 in accordance with setting operations accomplished by service staff that maintains and inspects the equipment 110.

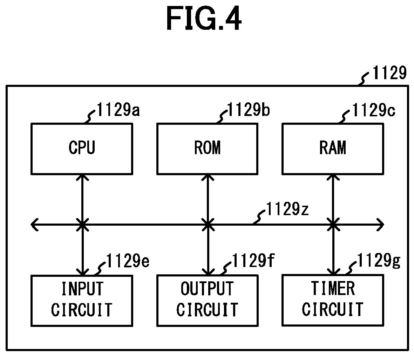

The calculator 1129 comprises a microcontroller possessing a CPU (Central Processing Unit) 1129a, a ROM (Read Only Memory) 1129b, RAM (Random Access Memory) 1129c, an input circuit 1129e, an output circuit 1129f and a timer circuit 1129g, connected to each other via a bus 1129z, as shown in FIG. 4.

The CPU 1129a accomplishes total control of the power measuring apparatus 112 by executing a software process in accordance with a program stored in the ROM 1129b. The RAM 1129c temporarily stores data that is being processed during execution of the program by the CPU 1129a.

The input circuit 1129e inputs various signals respectively output from the address setting switch 1128, the A/D converter 1124 and the insulator circuit 1127, and outputs the various input signals to the CPU 1126a. The output circuit 1129f outputs signals output from the CPU 1126a to the A/D converter 1124 and the transmitter 1126. The timer circuit 1129g is a hardware timer and starts timing when a signal indicating the start of timing (hereafter called a start signal) is input from the CPU 1126a. In addition, the timer circuit 1129g stops timing when a preset time has elapsed and inputs an interrupt signal to the CPU 1126a.

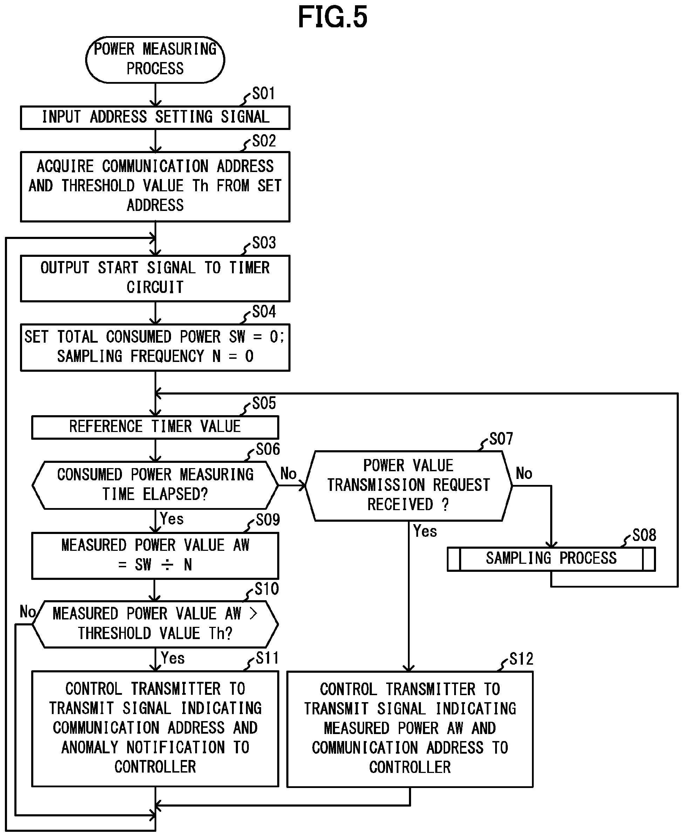

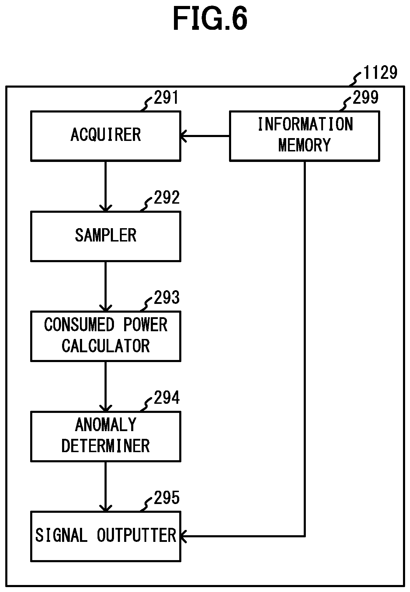

When power is supplied from the power source circuit 1121, the CPU 1129a begins executing the power measuring process shown in FIG. 5, and through this functions as an acquirer 291, a sampler 292, a consumed power calculator 293, an anomaly determiner 294 and a signal outputter 295, as shown in FIG. 6. In addition, the ROM 1129a functions as an information memory device 299.

The acquirer 291 acquires various types of signals from the input circuit 1129e and the timer circuit 1129g shown in FIG. 4. The sampler 292 samples the instantaneous power value (hereafter called the instantaneous consumed power value) W consumed by the equipment 110 based on the signal acquired by the acquirer 291. The consumed power calculator 293 calculates the average consumed power value based on the sampling frequency N and the total (hereafter called the total consumed power value) SW of the instantaneous consumed power values W sampled by the sampler 292. The anomaly determiner 294 determines whether or not an anomaly has occurred in the equipment 110 based on whether or not the average consumed power value calculated by the consumed power calculator 293 exceeds a threshold value Th that is an upper limit of the power consumed when the equipment 110 is operating normally. The signal outputter 295 outputs to the output circuit 1129f shown in FIG. 4 various types of signals such as a signal indicating the determination result of the anomaly determiner 294. The information memory 299 stores various types of preset data such as data indicating the communication address of the power measuring apparatus 112 and data indicating the threshold value Th.

When the power measuring process shown in FIG. 5 begins, the acquirer 291 acquires an address setting signal from the input circuit 1129e (step S01).

Next, the acquirer 291 acquires from the information memory 299 data up to a prescribed number of bytes from the address indicated by the address setting signal. Next, the acquirer 291 acquires data indicating the address identifying the power measuring apparatus 112 (that is to say, the communication address) in the monitoring control transmission line 20 and the transmission lines 21 and 22 connected thereto, and data indicating the threshold value Th, from the acquired data (step S02). An appropriate threshold value Th can be determined by the operator through experimentation.

Next, the signal outputter 295 outputs a signal ordering the timer circuit 1129g to initialize the stored timer value and begin timing (that is to say, a start signal) to the timer circuit 1129g (step S03).

Next, the acquirer 291 initializes a variable indicating the sampling frequency N of the R-S phase voltage, the S-T phase voltage, the R-phase current and the T-phase current impressed on the equipment 110 to the value "0". In addition, the acquirer 291 initializes a variable indicating the total consumed power value SW of the equipment 110 calculated using the sampled R-S phase voltage, S-T phase voltage, R-phase current and T-phase current to the value "0" (step S04).

Following this, the acquirer 291 references the timer value stored by the timer circuit 1129g (step S05). Next, the CPU 1129a determines whether or not the time indicated by the timer value is a time that has passed a predetermined time for measuring the consumed power of the equipment 110 (hereafter called the consumed power measuring time) (step S06). Data indicating the consumed power measuring time is stored in advance in the information memory 299.

When the acquirer 291 determines in step S06 that the time indicated by the timer value is not a time that has passed the consumed power measuring time (that is to say, when the time indicated by the timer value is a time before the consumed power measuring time elapses) (step S06: No), the acquirer 291 determines whether or not the transmitter 1126 has received from the controller 200 a request (hereafter called a power value transmission request) seeking the value of the measured consumed power (hereafter called the measured consumed power value) to be transmitted (step S07).

Specifically, when a signal from the transmitter 1126 is input to the input circuit 1129e, the acquirer 291 acquires the signal from the input circuit 1129e. The acquirer 291 references the destination field of data (hereafter called transmission data) indicated by the signal, based on a data format determined by the above-described protocol. Next, the acquirer 291 determines whether or not the address stored in the referenced field (hereafter called the destination address) matches the communication address read in step S02. When the destination address does not match the communication address, the acquirer 291 determines that the transmitted data is data with different equipment as the destination and discards the data. In contrast, when the determination is that the destination address matches the communication address, the acquirer 291 references the type field of the data based on the above-described data format and determines whether or not the referenced data is of a type indicating a power value transmission request. At this time, when the determination is that the referenced data is of a type indicating a power value transmission request, the acquirer 291 determines that a power value transmission request has been received by the transmitter 1126.

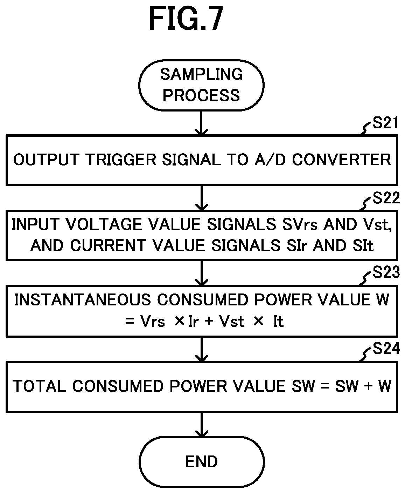

When the acquirer 291 determines in step S07 that the transmitter 1126 has not received a power value transmission request (step S07: No), a sampling process shown in FIG. 7 for sampling the instantaneous consumed power value W of the equipment 110 is executed (step S08), following which the above-described process from step S05 is repeated.

When the sampling process starts, the signal outputter 295 outputs the trigger signal to the output circuit 1129f (step S21). Following this, the output circuit 1129f outputs the trigger signal to the A/D converter 1124. Following this, when the input circuit 1129e inputs the voltage value signal SVrs and the voltage value signal SVst, and the current value signal SIr and the current value signal SIt, from the A/D converter 1124, the acquirer 291 acquires these signals from the input circuit 1129e (step S22).

Next, the sampler 292 calculates the instantaneous consumed power value W using the below equation (1) from the voltage value Vrs indicated by the voltage value signal SVrs, the voltage value Vst indicated by the voltage value signal SVst, the current value Ir indicated by the current value signal SIr and the current value It indicated by the current value signal SIt (step S23). In addition, the sampler 292 increases the value of the sampling frequency N by "1".

$$\text{Instantaneous consumed power value W} = \text{voltage value Vrs} \times \text{current value}$$

$$\text{Ir} + \text{voltage value Vst} \times \text{current value It} \qquad (1)$$

Following this, the sampler 292 updates the variable indicating the total consumed power value SW using the below equation (2) with a value found by adding the instantaneous consumed power value W calculated in step S23 to the power value SW indicated by the variable (step S24) and execution of the sampling process concludes.

$$\text{Total consumed power value SW} = \text{SW} + \text{instantaneous consumed power}$$

$$\text{value W} \qquad (2)$$

When the acquirer 291 determines in step S06 that the time indicated by the timer value is a time that is past the consumed power measuring time (step S06: Yes), the consumed power calculator 293 calculates the average consumed power value using the below equation (3), and calls the calculated value the measured power value AW (step S09).

$$\text{Measured power value AW} = \text{total consumed power value SW} \div \text{sampling}$$

$$\text{frequency N} \qquad (3)$$

Following this, the anomaly determiner 294 determines whether or not the calculated measured power value AW is larger than the threshold value Th read in step S02, and based on the determination results determines whether or not an anomaly has occurred in the equipment 110 (step S10). At this time, the anomaly determiner 294 has determined that the measured power value AW is not larger than the threshold value Th (the measured power value AW is no greater than the threshold value Th), so the determination is that an anomaly did not occur in the equipment 110 (step S10: No) and the above-described process is repeated from step S03.

In contrast, when the anomaly determiner 294 determines that an anomaly has occurred in the equipment 110 because it was determined that the measured power value AW is larger than the threshold value Th (step S10: Yes), the signal outputter 295 references from the information memory 299 the data format used in notifying of anomalies. Next, the signal outputter 295 reads the communication address of the controller 200 from the information memory 299 and stores the communication address of the controller 200 in the destination field of the communication data in accordance with the referenced data format. Next, the signal outputter 295 stores data indicating the communication address of the power measuring device 112 read in step S02, an anomaly notification providing notification that an anomaly occurred in the equipment 110, and the measured power value AW in the data field of the communication data in accordance with the referenced data format. Following this, the signal outputter 295 outputs the communication data to the output circuit 1129f, and the output circuit 1129f outputs the communication data to the transmitter 1126. In addition, the signal outputter 295 controls the transmitter 1126 so that a signal indicating the communication data is transmitted to the controller 200 (step S11). In the process of step S11, the signal outputter 295 for example implements access control known as CSMA/CD (Carrier Sense Multiple Access with Collision Detection). Following this, the above-described process is repeated from step S03.

When the acquirer 291 determines in step S07 that the transmitter 1126 has received a power value transmission request (step S07: Yes), the signal outputter 295 references from the information memory 299 the data format used in transmitting the measured power value AW. This data format differs from the data format used in monitoring and controlling the equipment 110 and 120.

Next, the signal outputter 295 stores the communication address of the controller 200 in the destination field of the communication data in accordance with the referenced data format. In addition, the signal outputter 295 stores data indicating the communication address read in step S02 and the measured power value AW calculated in step S09 in the data field of the communication data in accordance with the referenced data format. Following this, the signal outputter 295 outputs the communication data to the output circuit 1129f, and the output circuit 1129f outputs the communication data to the transmitter 1126. In addition, the signal outputter 295 controls the transmitter 1126 so that a signal indicating the communication data is transmitted to the controller 200 (step S12). Following this, the above-described process is repeated from step S03.

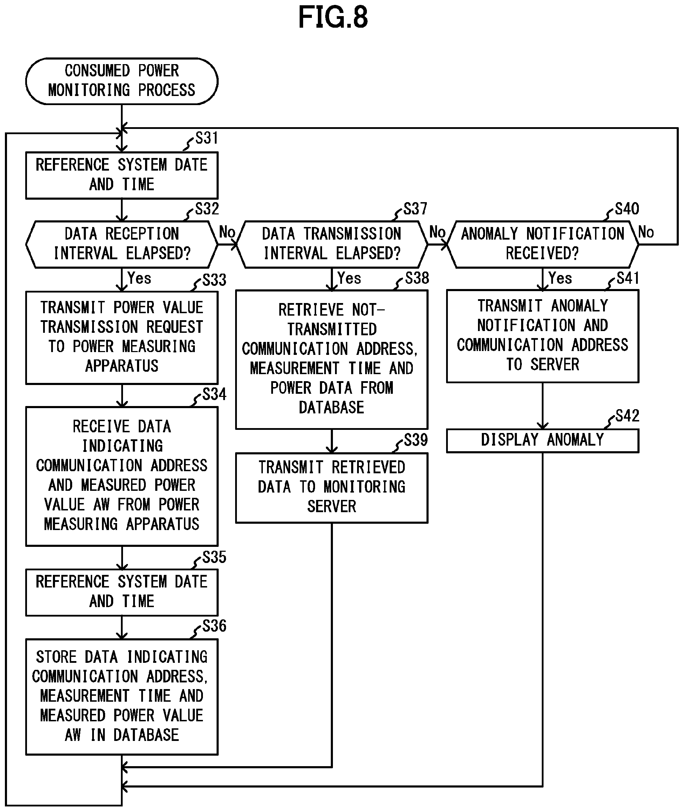

Next, the operation of the controller 200 is described with reference to FIG. 8.

When the consumed power monitoring process for monitoring power consumption by the equipment 110 and 120 begins, the controller 200 references the system date and time for example managed by the OS (operating system) (step S31).

Next, the controller 200 determines whether or not data indicating the measured power value AW has already been received after the consumed power monitoring process started. At this time, when it is determined that data indicating the measured power value AW has not been received even once since the consumed power monitoring process started, the controller 200 determines whether or not a predetermined reception interval (hereafter called the data reception interval) from the start of execution of the consumed power monitoring process has elapsed, based on the referenced system date and time. In contrast, when it is determined that data indicating the measured power value AW has already been received, the controller 200 determines whether or not the data reception time has elapsed from when data indicating the measured power value AW was received the prior time (step S32). The data reception interval is determined in advance for example by the above-described service staff, and data indicating the data reception interval that was set is stored in advance in the controller 200.

When the determination at this time is that the data reception interval time has elapsed (step S32: Yes), the controller 200 transmits a power value transmission request to the power measuring apparatus 112 installed in the equipment 110 and the power measuring apparatus installed in the equipment 120 (step S33).

Next, the controller 200 receives data indicating the measured power value AW and the communication address of the power measuring apparatus 112, from the power measuring apparatus 112 of the equipment 110, and receives data indicating the measured power value AW and the communication address of the power measuring apparatus, from the power measuring apparatus of the equipment 120 (step S34).

Next, the controller 200 again references the system date and time (step S35). Following this, the controller 200 sets the system date and time as the date and time when the power was measured (hereafter called the measurement date and time). Next, the controller 200 stores data associating data indicating the communication address, data indicating the measurement date and time, data indicating the measured power value AW and a flag indicating that data indicating the measured power value AW has not yet been transmitted to the monitoring server 300 (hereafter called the not-transmitted flag) in a database and repeats the above-described process from step S31.

When the determination in step S32 is that the data reception interval time has not elapsed (step S32: No), the controller 200 determines whether or not data indicating the measured power value AW has already been transmitted to the monitoring server 300 since the consumed power monitoring process started. At this time, when it is determined that data indicating the measured power value AW has not been transmitted even once since the consumed power monitoring process began, the controller 200 determines whether or not a predetermined interval (hereafter called the data transmission interval) has elapsed from the start of execution of the consumed power monitoring process, based on the system date and time referenced in step S31. In contrast, when it is determined that data indicating the measured power value AW has already been transmitted since the consumed power monitoring process started, the controller 200 determines whether or not the data transmission interval time has elapsed since transmission of data indicating the measured power value AW the previous time, based on the system date and time (step S37). The data transmission interval is preset for example by the above-described service staff and data indicating the data transmission interval that was set is stored in advance in the controller 200.

When it is determined in step S37 that the data transmission interval time has elapsed (step S37: Yes), the controller 200 retrieves from the database one or multiple items of data in which data indicating the communication address associated with data indicating the not-transmitted flag, data indicating the measurement date and time, and data indicating the measured power value AW are associated (step S38). Following this, the controller 200 transmits the retrieved one or multiple items of data to the monitoring server 300 (step S39).

In addition, the controller 200 updates a flag in which data indicating the transmitted communication address, data indicating the measurement date and time and data indicating the measured power value AW are associated together to a flag indicating that data indicating the measured power value AW has already been transmitted to the monitoring server 300 (hereafter called the transmitted flag) and then returns to step S31 and repeats the above-described process.

The monitoring server 300 forecasts future changes in consumed power for each equipment based on multiple items of data in which data indicating the communication address, data indicating the measurement date and time and data indicating the measured power value AW are associated together (that is to say, based on changes in past power consumption). In addition, the monitoring server 300 creates an operation schedule for the equipment so that the total power consumption for one day is smaller than a prescribed threshold value, for example, based on the future changes in consumed power, and transmits control signals to each piece of equipment so that the equipment operates in accordance with the created schedule. In other words, the monitoring server 300 realizes energy conservation and causes the peak of power consumed by the equipment to be reduced.

When the determination in step S37 is that the data transmission interval time has not elapsed (step S37: No), the controller 200 determines whether or not communication data indicating an anomaly notification has been received from the power measuring apparatus 112 of the equipment 110 or the power measuring apparatus of the equipment 120 (step S40). At this time, when it is determined that communication data indicating an anomaly notification has not been received (step S40: No), the controller 200 returns to step S31 and repeats the above-described process.

In contrast, when the determination is that communication data indicating an anomaly notification has been received (step S40: Yes), the controller 200 transmits communication data to the monitoring server 300 (step S41).

Data indicating the communication address of the equipment 110 and data indicating the communication address of the power measuring apparatus 112 for measuring power consumed by the equipment 110 are stored in advance associated with each other, in the controller 200 or the monitoring server 300. Similarly, data indicating the communication address of the equipment 120 and data indicating the communication address of the power measuring apparatus for measuring power consumed by the equipment 120 are stored in advance associated with each other, in the controller 200 or the monitoring server 300.

Consequently, the controller 200 or the monitoring server 300, upon receiving data indicating an anomaly notification and a communication address, retrieves data indicating the communication address of the equipment 110 or 120 associated with the communication address received. Next, the controller 200 or the monitoring server 300 displays on a display device the communication address of the power measuring apparatus that transmitted data indicating an anomaly notification, the communication address of the equipment for which the power measuring apparatus determined an anomaly, the fact that an anomaly was generated in the equipment, and the measured power value AW of the equipment (step S42).

Service staff who see the display by the controller 200 or the monitoring server 300 specify the equipment with a possibility that an anomaly or failure occurred, and manipulate the controller 200 or the monitoring server 300 so that for example a control signal causing operation to be halted, or a control signal causing an operation in accordance with the anomaly notification, such as an operation to lower the set temperature when the operation mode is heating, or an operation to raise the set temperature when the operation mode is cooling, or an operation to reduce the air volume, is transmitted to the specified equipment.

Following this, the controller 200 transmits the control signal to the equipment in accordance with the manipulation and then returns to step S31 and repeats the above-described process.

With this kind of composition, the power measuring apparatus 112 transmits data indicating the power consumed by the equipment 110 or 120 to the monitoring control transmission line 20 with which data used in monitoring the equipment 110 or 120 is transmitted. Consequently, even if the power measuring apparatus 112 is installed in the existing equipment 110 or 120, it is not necessary to newly lay a transmission line to the controller 200 for controlling the equipment 110 or 120 from the power measuring apparatus 112, so it is possible to install the power measuring apparatus 112 in the equipment 110 or 120 at lower installation cost than in the past.

In this preferred embodiment, the A/D converter 1124 was described as sampling the instantaneous value of the divided R-S phrase voltage and the instantaneous value of the divided S-T phase voltage, and the instantaneous value of the voltage in accordance with the R-phase current and the instantaneous value of the voltage in accordance with the T-phase current with roughly the same timing when a trigger signal is input from the calculator 1129. However, this is intended to be illustrative and not limiting, for the A/D converter 1124 may also correct the phase progression on the current side through the transformer CTr and the transformer CTt. Specifically, the A/D converter 1124 may accomplish the sampling timing on the current side (that is to say, the sampling timing of the instantaneous value of the voltage in accordance with the R-phase current and the instantaneous value of the voltage in accordance with the T-phase current) with a faster timing by the amount of phase progress determined by the properties of the transformer CTr and the transformer CTt than the sampling timing of the voltage side (that is to say, the sampling timing of the instantaneous value of the divided R-S phase voltage and the instantaneous value of the divided S-T phase voltage). The phase progress on the current side can be determined by an operator through experimentation. With this kind of composition, it is possible to more accurately measure power consumed by the equipment 110.

In this preferred embodiment, the power measuring apparatus 112 was described as measuring the current and voltage impressed on the equipment 110 from the line 11 connected to the control board 111 of the equipment 110, but this is intended to be illustrative and not limiting. For example, the power measuring apparatus 112 may further comprise a distribution board composed primarily of metal, and the power measuring apparatus 112 may measure the current and voltage impressed on the equipment 110 from the line connected to the distribution board.

In this preferred embodiment, the equipment 110 and 120 were described as comprising air conditioning equipment, but this is intended to be illustrative and not limiting, for the equipment may comprise, for example, lighting, ventilation fans, air conditioners, IH (Induction Heating) cooking heaters, rice cookers, microwave ovens, dryers, vacuum cleaners, washing machines or televisions.

In this preferred embodiment, the controller 200 was described as a modem device connectable to the monitoring server 300, but this is intended to be illustrative and not limiting, for it would be fine for the controller to be a server connectable to the monitoring server 300.

In addition, in this preferred embodiment the controller 200 was described as comprising a display device for displaying the measured power AW indicated by data received from the power measuring apparatus 112 and/or the like, but it would be fine for the controller 200 to be connected to a terminal having a display device and to control the terminal so as to display the measured power AW.

<Variation of first preferred embodiment>

In the first preferred embodiment, the power measuring apparatus 112 was described as transmitting a signal indicating an anomaly notification to the controller 200 (step S11) when it is determined that an anomaly has occurred in the equipment 110 (step S10: Yes), but this is intended to be illustrative and not limiting. The power measuring apparatus 112 can be constituted such that when the address setting switch is manipulated by the service staff, the communication address of the equipment 110 is specified and an anomaly has occurred in the equipment 110 (step S10: Yes), a signal indicating an anomaly notification is transmitted to the specified communication address. In this configuration, the equipment 110 can utilize a composition such that when a signal indicating an anomaly notification is received, operation is halted or an operation is accomplished in accordance with the anomaly notification, such as an operation to lower the set temperature when the operation mode is heating, an operation to raise the set temperature when the operation mode is cooling or an operation to decrease air volume.

With this kind of composition, the power measuring apparatus 112 transmits an anomaly notification to the equipment 110 when it is determined that an anomaly has occurred in the equipment 110. Consequently, even when for example the controller 200 controlling operation of the equipment 110 is unable to control operation of the equipment 110 in accordance with the anomaly notification, the equipment 110, upon receiving the anomaly notification, halts operation or accomplishes an operation in accordance with the anomaly notification, so it is possible to swiftly and with certainty prevent accidents or breakdown of the equipment 110.

<Second preferred embodiment>

The power measuring apparatus 112 according to a second preferred embodiment specifies a communication address specified by the equipment 110 from data transmitted to the monitoring control transmission line 20 within a prescribed time from when the power source is turned on in the equipment 110. The power measuring apparatus 112 according to the second preferred embodiment has a composition similar to that of the power measuring apparatus 112 according to the first preferred embodiment, so primarily points of difference from the power measuring apparatus 112 according to the first preferred embodiment are described.

The monitoring server 300 according to the second preferred embodiment further functions as a DHCP (Dynamic Host Configuration Protocol) or DNS (Domain Name System) server, and when power is turned on in the equipment 110, a communication address such as an IP (Internet Protocol) address, for example, is specified in the equipment 110 in accordance with a request transmitted from the equipment 110.

When it is determined that the power source has been turned on in the equipment 110 based on the power consumed by the equipment 110, the power measuring apparatus 112 according to the second preferred embodiment detects data that is data transmitted to the equipment 110 from the monitoring server 300 and specifies the communication address to the equipment 110 (hereafter called communication address specifying data).

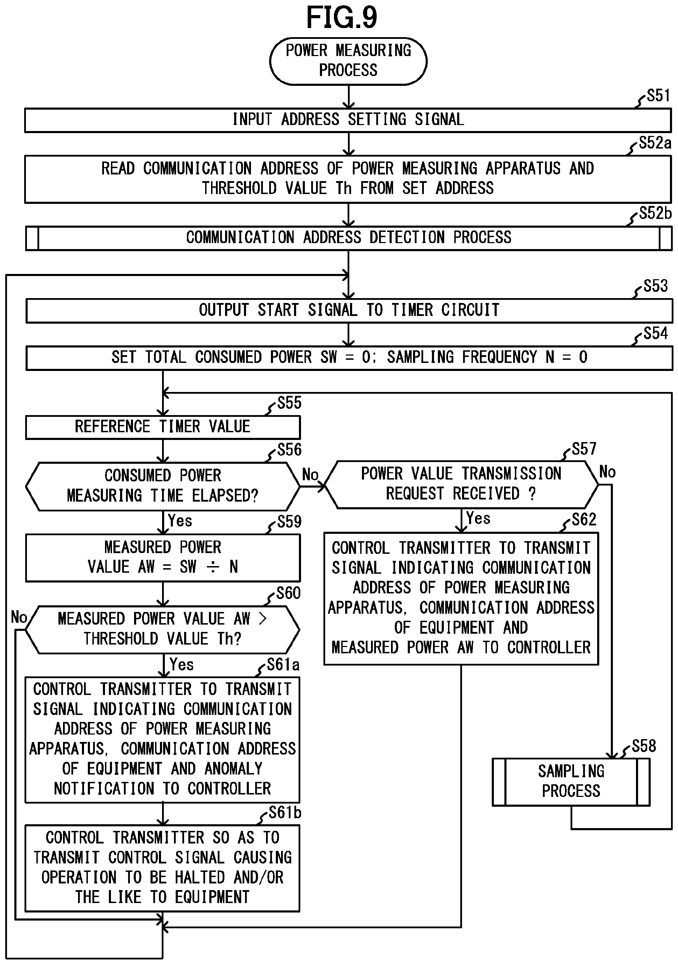

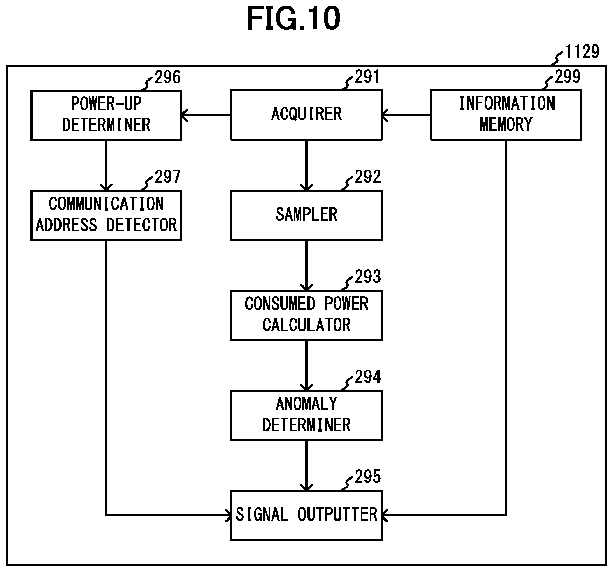

In order to demonstrate the above-described functions, the calculator 1129 of the power measuring apparatus 112 shown in FIG. 4 executes the power measuring process shown in FIG. 9. Through this, the CPU 1129a of the calculator 1129 functions as the acquirer 291, the sampler 292, the consumed power calculator 293, the anomaly determiner 294 and the signal outputter 295 shown in FIG. 10 and also as a power-up determiner 296 and a communication address detector 297.

The power-up determiner 296 determines whether or not the power source to the equipment 110 has been turned on, based on the amount of change in the instantaneous consumed power value W sampled by the sampler 292 and a threshold value Ton indicating the lower limit of the amount of change in the consumed power in the equipment 110 before and after power-up. The communication address detector 297 detects the communication address specified in the equipment 110, based on communication address specifying data transmitted to the monitoring control transmission line 20 within a prescribed time from when it is determined by the power-up determiner 296 that the power source has been turned on. The information memory 299 stores data indicating the threshold value Ton.

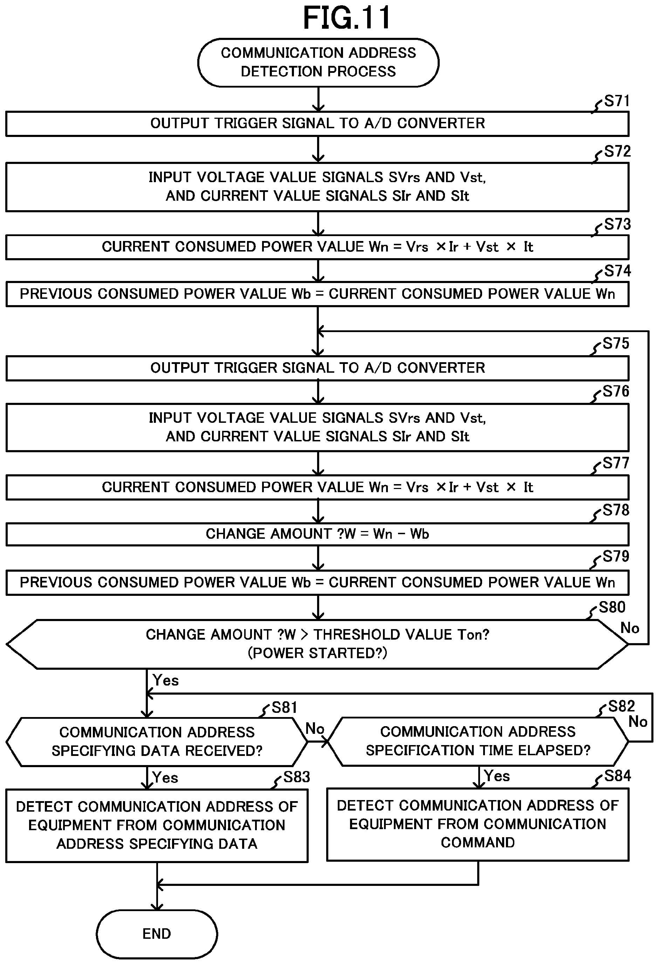

When the power measuring process of FIG. 9 starts, the acquirer 291 acquires an address setting signal from the input circuit 1129e (step S51). Next, the acquirer 291 acquires from the information memory 299 data from the address indicated by the address setting signal up to a prescribed byte. Next, the acquirer 291 acquires data indicating the communication address of the power measuring apparatus 112, and data indicating the threshold value Th, from the acquired data (step S52a). Following this, a communication address detection process such as that shown in FIG. 11 is executed to detect the communication address specified by the equipment 110 (step S52b).

When the communication address detection process shown in FIG. 11 starts, the same process as in step S21 to step S23 of FIG. 7 is executed (step S71 to step S73).

Next, the power-up determiner 296 stores an instantaneous consumed power value (hereafter called the current consumed power value) Wn of the equipment 110 calculated this time, in a variable storing the instantaneous consumed power value (hereafter called the previous consumed power value) Wb of the equipment 110 calculated the previous time (step S74).

Following this, the same process as in step S71 to step S73 is again executed (step S75 to step S77). Next, the power-up determiner 296 calculates the amount of change ΔW in the consumed power value by subtracting the previous consumed power value Wb from the current consumed power value Wn (step S78). Following this, the power-up determiner 296 executes the same process as in step S74 (step S79).

Next, the acquirer 291 acquires data indicating the threshold value Ton from the information memory 299, and the power-up determiner 296 determines whether or not the amount of change ΔW detected in step S78 is larger than the threshold value Ton. In addition, the power-up determiner 296 determines whether or not the power source of the equipment 110 was turned on, based on determination results for whether or not the amount of change ΔW is larger than the threshold value Ton (step S80).

When the power-up determiner 296 determines that the power source to the equipment 110 has been turned on because the amount of change ΔW is larger than the threshold value Ton (step S80: Yes), the communication address detector 297 determines whether or not the transmitter 1126 shown in FIG. 3 has received communication address specifying data with the equipment 110 as the destination from the monitoring server 300 (step S81).

At this time, when the communication address detector 297 determines that the communication address specifying data has not been received (step S81: No), a determination is made as to whether or not the time needed for the monitoring server 300 to specify a communication address (hereafter called the communication address specification time) has elapsed from when it was determined that the power source to the equipment was turned on in the equipment 110, based on the timer value of the timer circuit shown in FIG. 4 (step S82).

At this time, when the communication address detector 297 detects that the communication address specification time has not elapsed (step S82: No), the above-described process is repeated from step S81.

When it is determined in step S81 that the communication address specifying data has been received (step S81: Yes), execution of the communication address detection process concludes after data indicating the communication address specified in the equipment 110 is detected from the communication address specifying data (step S83).

When it is determined in step S82 that the communication address specification time has elapsed (step S82: Yes), the communication address detector 297 waits until the transmitter 1126 receives a communication command from the monitoring server 300 or the controller 200 manipulated by service staff. Next, the communication address detector 297 detects data indicating the communication address specified in the equipment 110 from the communication command that was received (step S84) and then concludes execution of the communication address detection process.

When execution of step S52b shown in FIG. 9 ends, the same process as in step S03 through step S10 of FIG. 5 is executed (step S52 to step S60).

When the anomaly determiner 294 determines in step S60 that an anomaly has occurred in the equipment 110 (step S60: Yes), the signal outputter 295 controls the transmitter 1126 so that a signal indicating communication data indicating the communication address of the power measuring apparatus 112 acquired in step S52a, the communication address of the equipment 110 detected in step S83 or in step S84 shown in FIG. 11, and an anomaly notification notifying that an anomaly has occurred in the equipment 110, is transmitted to the controller 200 (step S61a).

The controller 200 or the monitoring server 300 that receives communication data from the controller 200 displays the communication address of the power measuring apparatus 112, the communication address of the equipment 110 and the fact that an anomaly has occurred in the equipment 110, on a display device each possesses.

Following step S61a, the signal outputter 295 controls the transmitter 1126 so that a control signal causing operation to halt or a control signal causing operation in accordance with the anomaly notification is transmitted to the equipment 110, with the communication address of the equipment 110 detected in step S83 or step S84 as the destination (step S61b). Following this, the above-described process is repeated from step S53.

When the acquirer 291 determines in step S57 that the transmitter 1126 has received a power value transmission request (step S57: Yes), the signal outputter 295 controls the transmitter 1126 so that a signal indicating communication data indicating the communication address of the power measuring apparatus 112 acquired in step S52a, the communication addresses of the equipment 110 detected in step S83 or step S84 shown in FIG. 11, and the measured power value AW calculated in step S59, is transmitted to the controller 200 (step S62). Following this, the above-described process is repeated from step S53.

With this kind of composition, the communication address identifying the equipment 110 is detected from data transmitted to the monitoring control transmission line 20. Consequently, even if service staff installing the power measuring apparatus 112 in the equipment 110 do not know the communication address of the equipment 110, by simply installing the power measuring apparatus 112 in the equipment 110, a communication address identifying the equipment 110 and the power consumed by the equipment 110 can be transmitted to the monitoring control transmission line 20.

In addition, with this kind of composition, when it is determined that an anomaly has occurred in the equipment 110, the power measuring apparatus 112 transmits an anomaly notification with the communication address of the equipment 110 detected from data transmitted to the monitoring control transmission line 20 as the destination. Consequently, for example even when the controller 200 controlling operation of the equipment 110 cannot control operation of the equipment 110 in accordance with the anomaly notification, when the equipment 110 receives the anomaly notification, operation is halted or operation in accordance with the anomaly notification is accomplished, so it is possible to swiftly and with certainty prevent accidents or breakdown of the equipment 110.

<Third preferred embodiment>

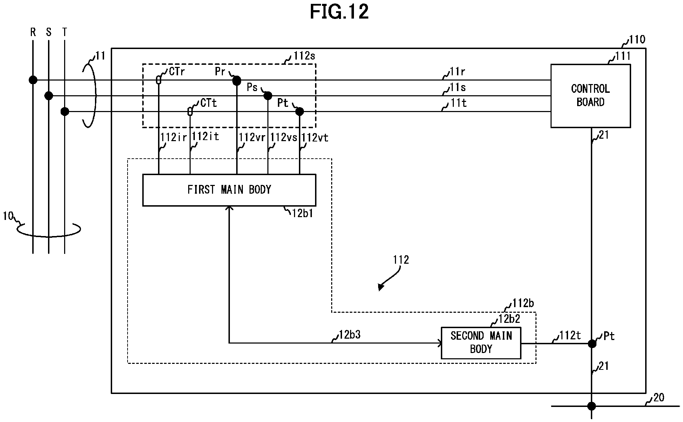

The main body 112b of the power measuring apparatus 112 according to a third preferred embodiment comprises a first main body 12b1 connected to the line 11, a second main body 12b2 connected to the transmission line 21, and transmission line 12b3 connected to the first main body 12b1 and the second main body 12b2 so as to enable communication, as shown in FIG. 12. The power measuring apparatus 112 according to the third preferred embodiment has the same composition as the power measuring apparatus 112 according to the first preferred embodiment, so below primarily the points of difference are described.

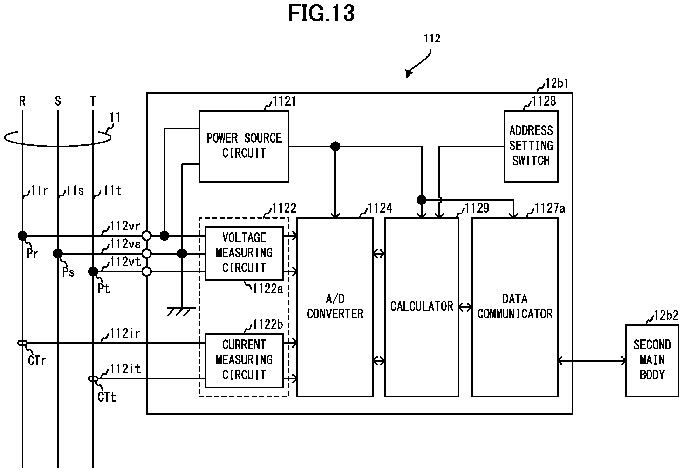

The first main body 12b1 comprises a power source circuit 1121, a measuring circuit 1122, an A/D converter 1124, an address setting switch 1128 and a calculator 1129, an also a data communicator 1127a, as shown in FIG. 13.

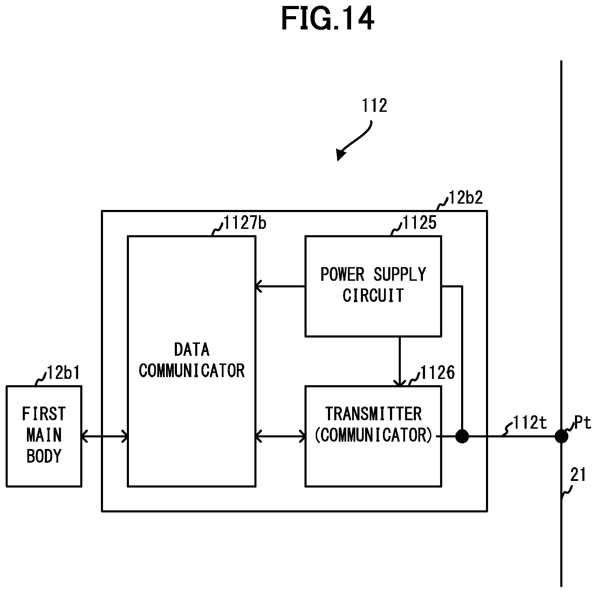

The second main body 12b2 comprises a power supply circuit 1125 and a transmitter 1126 along with a data communicator 1127b, as shown in FIG. 14.

The power source circuit 1121 of the first main body 12b1 shown in FIG 13 supplies power to the data communicator 1127a along with the A/D converter 1124 and the calculator 1129. The calculator 1129 accomplishes input and output of data with the transmitter 1126 shown in FIG. 14, via the data communicator 1127a. The data communicator 1127a accomplishes wired communication with the data communicator 1127b in the second main body 12b2, as shown in FIG.14.

A power supply circuit 1125 in the second main body 12b2 shown in FIG. 14 supplies power to the data communicator 1127b along with the transmitter 1126. The transmitter 1126 outputs data received from the transmission line 112t to the calculator 1129 shown in FIG. 13 via the data communicator 1127b. Conversely, the transmitter 1126 inputs data output from the calculator 1129 via the data communicator 1127b and transmits to the transmission line 112t a signal indicating the data that was output.

With this kind of composition, the power measuring apparatus 112 comprises the first main body 12b1 connected to the power source line 11 for calculating the power consumed by the equipment 110 based on the current and voltage impressed on the equipment 110 through the line 11, and the second main body 12b2 connected to the monitoring control transmission line 20 for transmitting data indicating consumed power to the monitoring control transmission line 20. Consequently, if the first main body 12b1 and the second main body 12b2 can only communicate, it is possible to measure the power consumed by the equipment 110 and to transmit data indicating the measured power to the monitoring control transmission line 20 even if the power source line 11 and the monitoring control transmission line 20 are placed at a more distant location than in the past. That is to say, freedom of positioning the power measuring apparatus 112 in the equipment 110 is increased.

In this preferred embodiment, the data communicator 1127a of the first main body 12b1 and the data communicator 1127b of the second main body 12b2 were described as communicating data via the transmission line 12b3, but this is intended to be illustrative and not limiting. For example, when the first main body 12b1 and the second main body 12b2 are sufficiently separated from the metal control board 111, the data communicator 1127a of the first main body 12b1 and the data communicator 1127b of the second main body 12b2 may communicate data wirelessly.

With this composition, if the first main body 12b1 is connected to the power source line 11 and the second main body 12b2 is connected to the monitoring control transmission line 20, it is possible for the first main body 12b1 and the second main body 12b2 to communicate data wirelessly. Consequently, compared to the case where the first main body 12b1 and the second main body 12b2 have wired communication, freedom of positioning the power measuring apparatus 112 in the equipment 110 is increased.

It is possible to provide a composition for realizing the functions according to the first preferred embodiment of the present disclosure, the variation of the first preferred embodiment, the second preferred embodiment or the third preferred embodiment as the power measuring apparatus 112 prepared in advance, and it is also possible to cause an existing power measuring apparatus to function as power measuring apparatus 112 of the first preferred embodiment, the variation of the first preferred embodiment, the second preferred embodiment or the third preferred embodiment through application of a program. That is to say, through application so that a program for causing the functional composition of the power measuring apparatus 112 illustrated by the above-described first preferred embodiment, variation of the first preferred embodiment, second preferred embodiment or third preferred embodiment to be realized is executed by a computer (CPU and/or the like) controlling an existing power measuring apparatus 112, it is possible to cause the existing power measuring apparatus to function as the power measuring apparatus 112 according to the first preferred embodiment, the variation of the first preferred embodiment, the second preferred embodiment or the third preferred embodiment.

The distribution method of such a program is arbitrary, and for example it is possible to store and distribute the program on a memory medium such as a memory card, possible to store and distribute the program on a memory medium such as a memory card, CD-ROM or DVD-ROM and/or the like, or to distribute the program via a communication medium such as the Internet and/or the like. The power measuring method of the present disclosure can be implemented using the power measuring system.

Industrial Applicability

The present disclosure applies to a power measuring apparatus for measuring power consumed by equipment such as an air conditioner.

Reference Signs List

[0114 Pr, Ps, Pt Point

Pt Transmission line connector

CTr, CTt Transformer

10 Three-phase alternating current power source

11, 12 Power source line

11r R phase of power source line 11

11s S phase of power source line 11

11t T phase of power source line 11

20 Monitoring control transmission line

30 Communication network

110, 120 Equipment

111 Control board

112 Power measuring apparatus

112b Main body

112ir, 112it, 112vr, 112vs, 112vt Lines

112s Line connector

112t Transmission line

200 Controller

300 Monitoring server

1121 Power source circuit

1122 Measuring circuit

1122a Voltage measuring circuit

1122b Current measuring circuit

1124 A/D converter

1125 Power supply circuit

1126 Transmitter

1127 Insulator circuit

1127a, 1127b Data communicator

1128 Address setting switch

1129 Calculator

1129a CPU

1129b ROM

1129c RAM

1129e Input circuit

1129f Output circuit

1129g Timer circuit

1129z Bus

291 Acquirer

292 Sampler

293 Consumed power calculator

294 Anomaly determiner

295 Signal outputter

296 Power-up determiner

297 Communication address detector

299 Information memory

## Claims

1.  A power measuring apparatus (112) **characterized by** comprising:

    line connecting means (112s) connected to a line (11) supplying power to equipment (110) which is connected to a control monitoring transmission line (21) dedicated for use by the equipment (110), the control monitoring transmission line (21) being used to transmit data for control monitoring;
    measuring means (1122) for measuring current and voltage impressed on the equipment (110) by the line (11) connected thereto;

calculating means (1129) for calculating instantaneous power value consumed by the equipment (110) based on the measured voltage and current;

transmission line connecting means (Pt) connected to the control monitoring transmission line (21);

transmitting means (1126) for transmitting data indicating the calculated instantaneous power value to the control monitoring transmission line (21).

2.  The power measuring apparatus (112) according to Claim 1, further **characterized by** comprising:

power-up determining means (296) for determining whether or not power to the equipment (110) has been turned on, based on the calculated instantaneous power value; and

address detecting means (297) for detecting data indicating a communication address specified in the equipment (110) from data transmitted to the control monitoring transmission line (21), within a prescribed time from when it is determined that power to the equipment (110) has been turned on;

wherein the transmitting means (1126) associates data indicating the communication address of the equipment (110) specified by the detected data, and data indicating the calculated instantaneous power value consumed by the equipment (110), with each other and transmits such to the control monitoring transmission line (21).

3.  The power measuring apparatus (112) according to Claim 1 or 2, further comprising:

anomaly determining means (294) for determining whether or not an anomaly has occurred in the equipment (110), based on the instantaneous power value calculated by the calculating means (293) and a threshold value indicating the upper limit of instantaneous power value consumed when the equipment (110) is operating normally;

wherein when the anomaly determining means (294) determines that an anomaly has occurred in the equipment (110), the transmitting means (1126) transmits a control signal causing a halting of operation or causing operation in accordance with the anomaly to be accomplished over the control monitoring transmission line (21), with designating the equipment as the destination (110).

4.  The power measuring apparatus (112) according to any one of Claims 1 through 3, **characterized by** comprising:

a first section (12b1) comprising the line connecting means (112s), the measuring means (1122) and the calculating means (1129), this section transmitting data indicating the instantaneous power value calculated by the calculating means (1129); and

a second section (12b2) comprising the transmission line connecting means (Pt) and the transmitting means (1126), this section receiving data indicating the instantaneous power value from the first section (12b1);

wherein the transmitting means (1126) transmits the received data indicating the instantaneous power value to the control monitoring transmission line (21).

5.  The power measuring apparatus (112) according to Claim 4, **characterized in that** the first section (12b1) and the second section (12b2) wirelessly send data indicating the instantaneous power value.

6.  A power measuring system (1) **characterized by** comprising:

a power measuring apparatus (112) according to Claim 1; and

a controller for controlling operation of the equipment (110) based on the instantaneous power value indicated by the transmitted data.

7.  The power measuring system (1) according to Claim 6, **characterized in that**:

the power measuring apparatus (112) determines that an anomaly has occurred in the equipment (110) based on a threshold value indicating the upper limit of instantaneous power value consumed when the equipment (110) is operating normally and the calculated instantaneous power value consumed by the equipment (110), and transmits an anomaly notification indicating that an anomaly has occurred in the equipment (110) to the equipment (110); and

the equipment (110) halts operation or accomplishes operation in accordance with the anomaly notification upon receiving the anomaly notification.

8.  A power measuring method **characterized by** including:

a measuring step for measuring current and voltage impressed on equipment (110) by a line (11) supplying power to the equipment (110) which is connected to a control monitoring transmission line (21) dedicated for use by the equipment (110), the control monitoring transmission line (21) being used to transmit data for control monitoring;

a calculating step for calculating an instantaneous power value consumed by the equipment (110) based on the measured current and voltage; and

a transmitting step for transmitting data indicating the calculated instantaneous power value to the control monitoring transmission line (21).

**Patentansprüche**

1. Leistungsmessvorrichtung (112), **dadurch gekennzeichnet, dass** sie umfasst:

ein Leitungsverbindungsmittel (112s), das mit einer Leitung (11) verbunden ist, die eine Ausrüstung (110), die mit einer Steuerungsüberwachungsübertragungsleitung (21) verbunden ist, die zur Verwendung durch die Ausrüstung (110) bestimmt ist, mit Leistung versorgt, wobei die Steuerungsüberwachungsübertragungsleitung (21) verwendet wird, um Daten für Steuerungsüberwachung zu übertragen;

ein Messmittel (1122) zum Messen von Strom und Spannung, die auf die Ausrüstung (110) durch die mit ihr verbundene Leitung (11) aufgebracht werden;

ein Berechnungsmittel (1129) zum Berechnen des Momentanleistungswerts, der von der Ausrüstung (110) verbraucht wird, auf der Grundlage der/des gemessenen Spannung und Stroms;

ein Übertragungsleitungsverbindungsmittel (Pt), das mit der Steuerungsüberwachungsübertragungsleitung (21) verbunden ist;

ein Übertragungsmittel (1126) zum Übertragen von Daten, anzeigend den berechneten Momentanleistungswert, an die Steuerungsüberwachungsübertragungsleitung (21).

2. Leistungsmessvorrichtung (112) nach Anspruch 1, ferner **dadurch gekennzeichnet, dass** sie umfasst:

ein Einschalt-Bestimmungsmittel (296) zum Bestimmen, ob oder ob nicht Leistung an die Ausrüstung (110) eingeschaltet wurde, auf der Grundlage des berechneten Momentanleistungswerts; und

ein Adresserfassungsmittel (297) zum Erfassen von Daten, anzeigend eine in der Ausrüstung (110) spezifizierte Kommunikationsadresse aus den an die Steuerungsüberwachungsübertragungsleitung (21) übertragenen Daten, innerhalb einer vorgeschriebenen Zeit ab dem Zeitpunkt, zu dem bestimmt wurde, dass Leistung an die Ausrüstung (110) eingeschaltet wurde;

wobei das Übertragungsmittel (1126) Daten, anzeigend die durch die erfassten Daten spezifizierte Kommunikationsadresse der Ausrüstung (110), und Daten, anzeigend den von der Ausrüstung (110) verbrauchten berechneten Momentanleistungswert, miteinander assoziiert und diese an die Steuerungsüberwachungsübertragungsleitung (21) überträgt.

3. Leistungsmessvorrichtung (112) nach Anspruch 1 oder 2, ferner umfassend:

ein Anomalität-Bestimmungsmittel (294) zum Bestimmen, ob oder ob nicht eine Anomalität in der Ausrüstung (110) aufgetreten ist, auf der Grundlage des durch das Berechnungsmittel (293) berechneten Momentanleistungswerts und eines Schwellenwerts, anzeigend die obere Grenze des Momentanleistungswerts, der verbraucht wird, wenn die Ausrüstung (110) normal arbeitet;

wobei, wenn das Anomalität-Bestimmungsmittel (294) bestimmt, dass eine Anomalität in der Ausrüstung (110) aufgetreten ist, das Übertragungsmittel (1126) ein Steuersignal überträgt, das ein Anhalten des Betriebs veranlasst oder Vollenden des Durchführens von Betrieb gemäß der Anormalität veranlasst über die Steuerungsüberwachungsübertragungsleitung (21), mit Bezeichnung der Ausrüstung als das Ziel (110).

4. Leistungsmessvorrichtung (112) nach einem der Ansprüche 1 bis 3, **dadurch gekennzeichnet, dass** sie umfasst:

einen ersten Abschnitt (12b1), umfassend das Leitungsverbindungsmittel (112s), das Messmittel (1122) und das Berechnungsmittel (1129), wobei dieser Abschnitt Daten überträgt, die den durch das Berechnungsmittel (1129) berechneten Momentanleistungswert anzeigen; und

einen zweiten Abschnitt (12b2), umfassend das Übertragungsleitungsverbindungsmittel (Pt) und das Übertragungsmittel (1126), wobei dieser Abschnitt Daten empfängt, die den Momentanleistungswert vom ersten Abschnitt (12b1) anzeigen;
wobei das Übertragungsmittel (1126) die empfangenen Daten, anzeigend den Momentanleistungswert, an die Steuerungsüberwachungsübertragungsleitung (21) überträgt.

5. Leistungsmessvorrichtung (112) nach Anspruch 4, **dadurch gekennzeichnet, dass** der erste Abschnitt (12b1) und der zweite Abschnitt (12b2) den Momentanleistungswert anzeigende Daten drahtlos senden.

6. Leistungsmesssystem (1), **dadurch gekennzeichnet, dass** es umfasst:

eine Leistungsmessvorrichtung (112) nach Anspruch 1; und
eine Steuereinheit zum Steuern des Betriebs der Ausrüstung (110) auf der Grundlage des durch die übertragenen Daten angezeigten Momentanleistungswerts.

7. Leistungsmesssystem (1) nach Anspruch 6, **dadurch gekennzeichnet, dass**:

die Leistungsmessvorrichtung (112) bestimmt, dass eine Anomalität in der Ausrüstung (110) aufgetreten ist auf der Grundlage eines Schwellenwertes, anzeigend die obere Grenze des Momentanleistungswerts, der verbraucht wird, wenn die Ausrüstung (110) normal arbeitet, und des durch die Ausrüstung (110) verbrauchten berechneten Momentanleistungswerts, und eine Anomalitätsmeldung, anzeigend, dass eine Anomalität in der Ausrüstung (110) aufgetreten ist, an die Ausrüstung (110) überträgt; und
die Ausrüstung (110) Betrieb anhält oder Vollendung des Betriebs gemäß der Anomalitätsmeldung auf Empfangen der Anomalitätsmeldung hin durchführt.

8. Leistungsmessverfahren, **dadurch gekennzeichnet, dass** es umfasst:

ein Messschritt zum Messen von Strom und Spannung, die auf die Ausrüstung (110) durch eine Leitung (11) aufgebracht werden, die die Ausrüstung (110), die mit einer Steuerungsüberwachungsübertragungsleitung (21) verbunden ist, die zur Verwendung durch die Ausrüstung (110) bestimmt ist, mit Leistung versorgt, wobei die Steuerungsüberwachungsübertragungsleitung (21) verwendet wird, um Daten für Steuerungsüberwachung zu übertragen;
einen Berechnungsschritt zum Berechnen eines Momentanleistungswerts, der von der Ausrüstung (110) verbraucht wird, auf der Grundlage des/der gemessenen Stroms und Spannung; und
einen Übertragungsschritt zum Übertragen von Daten, anzeigend den berechneten Momentanleistungswert, an die Steuerungsüberwachungsübertragungsleitung (21).

## Revendications

1. Appareil de mesure de puissance (112) **caractérisé en ce qu'**il comprend :

un moyen de connexion de ligne (112s) connecté à une ligne (11) fournissant de l'énergie à un équipement (110) qui est connecté à une ligne de transmission de surveillance de commande (21) destinée à être utilisée par l'équipement (110), la ligne de transmission de surveillance de commande (21) étant utilisée en vue de transmettre des données à des fins de surveillance de commande ;
un moyen de mesure (1122) pour mesurer un courant et une tension appliqués à l'équipement (110) par la ligne (11) connectée à celui-ci ;
un moyen de calcul (1129) pour calculer une valeur de puissance instantanée consommée par l'équipement (110) sur la base de la tension et du courant mesurés ;
un moyen de connexion de ligne de transmission (Pt) connecté à la ligne de transmission de surveillance de commande (21) ;
un moyen de transmission (1126) pour transmettre des données indiquant la valeur de puissance instantanée calculée à la ligne de transmission de surveillance de commande (21).

2. Appareil de mesure de puissance (112) selon la revendication 1, **caractérisé en outre en ce qu'**il comprend :

un moyen de détermination de mise sous tension (296) pour déterminer si l'alimentation de l'équipement (110) a été mise sous tension ou non, sur la base de la valeur de puissance instantanée calculée ; et
un moyen de détection d'adresse (297) pour détecter des données indiquant une adresse de communication spécifiée dans l'équipement (110) à partir de données transmises à la ligne de transmission de surveillance de commande (21), dans un délai prescrit à partir de l'instant où il est déterminé que l'alimentation de l'équipement (110) a été mise sous tension ;

dans lequel le moyen de transmission (1126) associe entre elles des données indiquant l'adresse de communication de l'équipement (110) spécifiée par les données détectées, et des données indiquant la valeur de puissance instantanée calculée consommée par l'équipement (110), et transmet ces données à la ligne de transmission de surveillance de commande (21).

3. Appareil de mesure de puissance (112) selon la revendication 1 ou 2, comprenant en outre :

un moyen de détermination d'anomalie (294) pour déterminer si une anomalie s'est produite ou non dans l'équipement (110), sur la base de la valeur de puissance instantanée calculée par le moyen de calcul (293) et d'une valeur de seuil indiquant la limite supérieure de la valeur de puissance instantanée consommée lorsque l'équipement (110) fonctionne normalement ;

dans lequel, lorsque le moyen de détermination d'anomalie (294) détermine qu'une anomalie a été rencontrée dans l'équipement (110), le moyen de transmission (1126) transmet un signal de commande occasionnant une interruption du fonctionnement, ou occasionnant un fonctionnement selon l'anomalie, à mettre en oeuvre sur la ligne de transmission de surveillance de commande (21), avec désignation de l'équipement en qualité de destination (110).

4. Appareil de mesure de puissance (112) selon l'une quelconque des revendications 1 à 3, **caractérisé en ce qu'**il comprend :

une première section (12b1) comprenant le moyen de connexion de ligne (112s), le moyen de mesure (1122) et le moyen de calcul (1129), ladite section transmettant des données indiquant la valeur de puissance instantanée calculée par le moyen de calcul (1129) ; et

une seconde section (12b2) comprenant le moyen de connexion de ligne de transmission (Pt) et le moyen de transmission (1126), ladite section recevant des données indiquant la valeur de puissance instantanée en provenance de la première section (12b1) ;

dans lequel le moyen de transmission (1126) transmet les données reçues indiquant la valeur de puissance instantanée à la ligne de transmission de surveillance de commande (21).

5. Appareil de mesure de puissance (112) selon la revendication 4, **caractérisé en ce que** la première section (12b1) et la seconde section (12b2) envoient, par voie hertzienne, des données indiquant la valeur de puissance instantanée.

6. Système de mesure de puissance (1) **caractérisé en ce qu'**il comprend :

un appareil de mesure de puissance (112) selon la revendication 1 ; et

un contrôleur pour commander le fonctionnement de l'équipement (110) sur la base de la valeur de puissance instantanée indiquée par les données transmises.

7. Système de mesure de puissance (1) selon la revendication 6, **caractérisé en ce que** :

l'appareil de mesure de puissance (112) détermine qu'une anomalie a été rencontrée dans l'équipement (110), sur la base d'une valeur de seuil indiquant la limite supérieure de la valeur de puissance instantanée consommée lorsque l'équipement (110) fonctionne normalement, et de la valeur de puissance instantanée calculée consommée par l'équipement (110), et transmet une notification d'anomalie indiquant qu'une anomalie a été rencontrée dans l'équipement (110), à l'équipement (110) ; et

l'équipement (110) interrompt le fonctionnement, ou met en oeuvre un fonctionnement selon la notification d'anomalie suite à la réception de la notification d'anomalie.

8. Procédé de mesure de puissance, **caractérisé en ce qu'**il comprend :

une étape de mesure consistant à mesurer un courant et une tension appliqués à un équipement (110) par une ligne (11) fournissant de l'énergie à l'équipement (110) qui est connecté à une ligne de transmission de surveillance de commande (21) destinée à être utilisée par l'équipement (110), la ligne de transmission de surveillance de commande (21) étant utilisée en vue de transmettre des données à des fins de surveillance de commande ;

une étape de calcul consistant à calculer une valeur de puissance instantanée consommée par l'équipement (110), sur la base du courant et de la tension mesurés ; et

une étape de transmission consistant à transmettre des données indiquant la valeur de puissance instantanée calculée, à la ligne de transmission de surveillance de commande (21).

# FIG.1

EQUIPMENT 110

EQUIPMENT 120

MONITORING SERVER 300

CONTROLLER 200

# FIG.2

FIG.3

# FIG.4

# FIG.5

```
        ┌─────────────────────┐
        │  POWER MEASURING    │
        │     PROCESS         │
        └─────────────────────┘
                 │
                 ▼                    S01
    ┌─────────────────────────────────┐
    │   INPUT ADDRESS SETTING SIGNAL  │
    └─────────────────────────────────┘
                 │
                 ▼                    S02
    ┌─────────────────────────────────┐
    │  ACQUIRE COMMUNICATION ADDRESS  │
    │  AND THRESHOLD VALUE Th FROM SET│
    │            ADDRESS              │
    └─────────────────────────────────┘
                 │
                 ▼                    S03
    ┌─────────────────────────────────┐
    │   OUTPUT START SIGNAL TO TIMER  │
    │            CIRCUIT              │
    └─────────────────────────────────┘
                 │
                 ▼                    S04
    ┌─────────────────────────────────┐
    │ SET TOTAL CONSUMED POWER SW = 0;│
    │   SAMPLING FREQUENCY N = 0      │
    └─────────────────────────────────┘
                 │
                 ▼                    S05
    ┌─────────────────────────────────┐
    │      REFERENCE TIMER VALUE      │
    └─────────────────────────────────┘
```

S06 — CONSUMED POWER MEASURING TIME ELAPSED?  — No → S07 — POWER VALUE TRANSMISSION REQUEST RECEIVED ? — No → S08 SAMPLING PROCESS

S06 Yes ↓

S09 — MEASURED POWER VALUE AW = SW ÷ N

S10 — MEASURED POWER VALUE AW > THRESHOLD VALUE Th? — No

S10 Yes ↓

S11 — CONTROL TRANSMITTER TO TRANSMIT SIGNAL INDICATING COMMUNICATION ADDRESS AND ANOMALY NOTIFICATION TO CONTROLLER

S07 Yes ↓

S12 — CONTROL TRANSMITTER TO TRANSMIT SIGNAL INDICATING MEASURED POWER AW AND COMMUNICATION ADDRESS TO CONTROLLER

# FIG.6

# FIG.7

```
        ┌─────────────────┐
        │    SAMPLING     │
        │    PROCESS      │
        └────────┬────────┘
                 │              ╭S21
    ┌────────────▼─────────────────────┐
    │ OUTPUT TRIGGER SIGNAL TO A/D CONVERTER │
    └────────────┬─────────────────────┘
                 │              ╭S22
    ┌────────────▼─────────────────────┐
    │ INPUT VOLTAGE VALUE SIGNALS SVrs AND Vst, │
    │ AND CURRENT VALUE SIGNALS SIr AND SIt │
    └────────────┬─────────────────────┘
                 │              ╭S23
    ┌────────────▼─────────────────────┐
    │ INSTANTANEOUS CONSUMED POWER VALUE W │
    │      = Vrs × Ir + Vst × It        │
    └────────────┬─────────────────────┘
                 │              ╭S24
    ┌────────────▼─────────────────────┐
    │ TOTAL CONSUMED POWER VALUE SW = SW + W │
    └────────────┬─────────────────────┘
                 │
        ┌────────▼────────┐
        │       END       │
        └─────────────────┘
```

# FIG.8

```
        ┌─────────────────────┐
        │  CONSUMED POWER     │
        │ MONITORING PROCESS  │
        └─────────────────────┘
```

S31
REFERENCE SYSTEM DATE
AND TIME

S32
DATA RECEPTION
INTERVAL ELAPSED?          No → 

S37
DATA TRANSMISSION
INTERVAL ELAPSED?          No →

S40
ANOMALY NOTIFICATION
RECEIVED?                  No

Yes                        Yes                        Yes

S33
TRANSMIT POWER VALUE
TRANSMISSION REQUEST
TO POWER MEASURING
APPARATUS

S38
RETRIEVE NOT-
TRANSMITTED
COMMUNICATION ADDRESS,
MEASUREMENT TIME AND
POWER DATA FROM
DATABASE

S41
TRANSMIT ANOMALY
NOTIFICATION AND
COMMUNICATION ADDRESS
TO SERVER

S34
RECEIVE DATA
INDICATING
COMMUNICATION ADDRESS
AND MEASURED POWER
VALUE AW FROM POWER
MEASURING APPARATUS

S39
TRANSMIT RETRIEVED
DATA TO MONITORING
SERVER

S42
DISPLAY ANOMALY

S35
REFERENCE SYSTEM DATE
AND TIME

S36
STORE DATA INDICATING
COMMUNICATION ADDRESS,
MEASUREMENT TIME AND
MEASURED POWER VALUE
AW IN DATABASE

# FIG.9

```
        ( POWER MEASURING )
        (     PROCESS      )
```

S51
INPUT ADDRESS SETTING SIGNAL

S52a
READ COMMUNICATION ADDRESS OF POWER MEASURING APPARATUS AND
THRESHOLD VALUE Th FROM SET ADDRESS

S52b
COMMUNICATION ADDRESS DETECTION PROCESS

S53
OUTPUT START SIGNAL TO TIMER CIRCUIT

S54
SET TOTAL CONSUMED POWER SW = 0; SAMPLING FREQUENCY N = 0

S55
REFERENCE TIMER VALUE

S56
CONSUMED POWER
MEASURING TIME ELAPSED?   No

S57
POWER VALUE TRANSMISSION
REQUEST RECEIVED ?   No

Yes   S59
MEASURED POWER
VALUE AW = SW ÷ N

Yes   S62
CONTROL TRANSMITTER TO TRANSMIT
SIGNAL INDICATING COMMUNICATION
ADDRESS OF POWER MEASURING
APPARATUS, COMMUNICATION ADDRESS
OF EQUIPMENT AND
MEASURED POWER AW TO CONTROLLER

No   S60
MEASURED POWER VALUE AW >
THRESHOLD VALUE Th?

Yes   S61a
CONTROL TRANSMITTER TO TRANSMIT
SIGNAL INDICATING COMMUNICATION
ADDRESS OF POWER MEASURING
APPARATUS, COMMUNICATION ADDRESS
OF EQUIPMENT AND ANOMALY
NOTIFICATION TO CONTROLLER

S61b
CONTROL TRANSMITTER SO AS TO
TRANSMIT CONTROL SIGNAL CAUSING
OPERATION TO BE HALTED AND/OR
THE LIKE TO EQUIPMENT

S58
SAMPLING
PROCESS

# FIG.10

# FIG.11

$$\boxed{\begin{array}{c}\text{COMMUNICATION ADDRESS}\\\text{DETECTION PROCESS}\end{array}}$$

S71

OUTPUT TRIGGER SIGNAL TO A/D CONVERTER

S72

INPUT VOLTAGE VALUE SIGNALS SVrs AND Vst,
AND CURRENT VALUE SIGNALS SIr AND SIt

S73

CURRENT CONSUMED POWER VALUE Wn = Vrs × Ir + Vst × It

S74

PREVIOUS CONSUMED POWER VALUE Wb = CURRENT CONSUMED POWER VALUE Wn

S75

OUTPUT TRIGGER SIGNAL TO A/D CONVERTER

S76

INPUT VOLTAGE VALUE SIGNALS SVrs AND Vst,
AND CURRENT VALUE SIGNALS SIr AND SIt

S77

CURRENT CONSUMED POWER VALUE Wn = Vrs × Ir + Vst × It

S78

CHANGE AMOUNT ?W = Wn − Wb

S79

PREVIOUS CONSUMED POWER VALUE Wb = CURRENT CONSUMED POWER VALUE Wn

S80

CHANGE AMOUNT ?W > THRESHOLD VALUE Ton?
(POWER STARTED?) — No

Yes

S81

COMMUNICATION ADDRESS
SPECIFYING DATA RECEIVED? — No

S82

COMMUNICATION ADDRESS
SPECIFICATION TIME ELAPSED? — No

Yes

S83

DETECT COMMUNICATION ADDRESS OF
EQUIPMENT FROM COMMUNICATION
ADDRESS SPECIFYING DATA

Yes

S84

DETECT COMMUNICATION ADDRESS OF
EQUIPMENT FROM COMMUNICATION
COMMAND

END

# FIG.12

EP 2 787 354 B1

# FIG.13

32

# FIG.14

**EP 2 787 354 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003149272 A
- JP 2004222375 A
- JP 2010065960 A